Europäisches Patentamt

European Patent Office

Office européen des brevets

(11) Publication number: **0 352 806**
**A2**

## (12) EUROPEAN PATENT APPLICATION

(21) Application number: **89113978.4**

(22) Date of filing: **28.07.89**

(51) Int. Cl.4: **G06F 12/08**

(30) Priority: **28.07.88 JP 189368/88**

(43) Date of publication of application:
**31.01.90 Bulletin 90/05**

(84) Designated Contracting States:
**DE FR GB IT**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Miyoshi, Akio**
**2-363-5, Morooka-Cho**
**Oome-shi Tokyo-To(JP)**
Inventor: **Hayakashi, Yoshiki 304, Kamiooka**
**Haidensu**
**1-11-22, Ookubo Konan-Ku**
**Yokohama-Shi Kanagawa-Ken(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Cache memory and access controller using such memory.

(57) A cache memory characterized by having, in the same chip, address tag divisions (13) storing address tags of stored data, a comparator (24) comparing an address tag (20) in external address (19) with the address tags in the address tag divisions (13), a circuit (25) generating internal hit signal depending on the output of the collator (24) and an OR circuit (7) outputting an OR signal of the internal hit signal and an external signal.

FIG. 3

EP 0 352 806 A2

## CACHE MEMORY AND ACCESS CONTROLLER USING SUCH MEMORY

### BACKGROUND OF THE INVENTION

This invention relates to cache memories and, more particularly, to cache memories required for high-speed access in use with high-order microcomputers and also to access controllers for processors using those cache memories.

Cache memories are provided between CPUs and main memories and are high-speed and small-capacity semiconductor memories to assist low-speed main memories. The cache memory includes data divisions storing data, address tag divisions storing the address tags of the stored data, a comparator comparing the address tags of the addresses given by the CPU with the address tags in the address tag divisions, and valid bits indicating the presence of data in each data area in the data division. The CPU gives an address of data to be read and the cache memory sends into the comparator the address tags both in the address and in the address tag division, makes the collator collate both tags for agreement, and returns a hit signal to the CPU if the tags coincide with each other and the valid bit of the corresponding data area is "1". Receiving the hit signal, the CPU judges that the desired data exists in the cache memory and receives the data read from the cache storage.

As described above, the hit signal is intended to inform the CPU whether or not the cache memory is accessible before data read. The CPU is required to receive the hit signal before receiving the read data. Thus, operation from addressing to sending the hit signal to the CPU requires high speed.

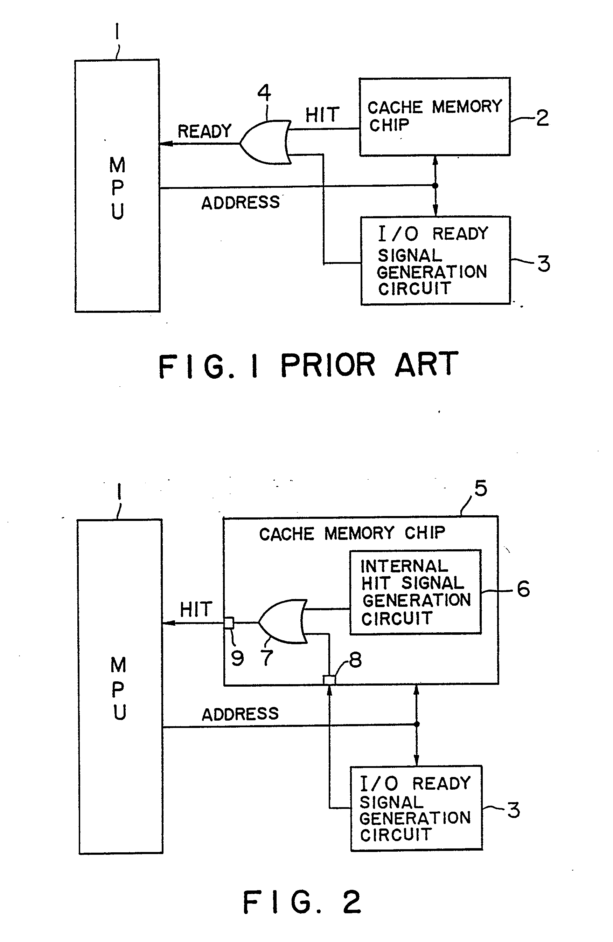

FIG. 1 shows a configuration of an access controller for a microprocessor (MPU) using a conventional cache memory chip. The MPU 1 is usually connected not only with the memory but also with an I/O unit via a bus, and ready signals to access the I/O unit are generated in an I/O ready signal generation circuit 3 in the I/O unit. The configuration shows that the ready signal from the I/O ready signal generation circuit 3 and the hit signal from the cache memory chip 2 are given to the ready input of the MPU 1 through the OR gate 4.

As described above, operation from addressing to sending the hit signal to the CPU requires a high speed. However, in the configuration shown in FIG. 1, where the hit signal sent from the cache memory chip 2 is given to MPU 1 via the OR gate 4 outside the chip, delay in transmitting the hit signal occurs due to wiring resistance across the cache memory chip 2 and the OR gate 4 and a relatively large time constant depending on the capacity. To eliminate this delay, the cache memory is required to transmit the hit signal at a very high speed. Even in this case, however, major MPUs of higher order than 16-bit or 32-bit type, which operate especially at a high speed, may be inoperable.

### BRIEF SUMMARY OF THE INVENTION

An object of this invention is to provide high-speed transmission of hit signals by eliminating gates built outside the cache memory chip.

According to this invention is provided a cache memory comprising, in a single chip, address tag divisions storing address tags of stored data, a comparator comparing an address tag in an external address to the address tags in the address tag divisions, a circuit generating an internal hit signal according to the output of the collator and an OR circuit outputting an OR signal of logical sum of the internal hit signal and an external signal.

According to this invention is further provided an access controller using such cache memories.

When the foregoing cache memory is used, no gate circuit in a chip other than the cache memory is required because ready signals and hit signals from other I/O units are entered as external signals into the OR circuit in the cache memory and the output of the OR circuit is given to the ready input of the CPU. In this case, because the internal hit signal generation circuit and the above-mentioned OR circuit are located on the same chip, the distance between both circuits is very short and the wiring resistance between both circuits and the time constant depending on the capacity are so small as to be negligible. Therefore, the internal hit signals issued by the cache memory itself are transmitted to the CPU at a very high speed. On the other hand, because ready signals and hit signals from other I/O units are transmitted to the CPU via the above-mentioned OR circuit which is an external circuit to the hardware, the transmission speed is the same as the prior art, and there are no practical problems because high speed is not required.

### BRIEF DESCRIPTION OF THE DRAWINGS

FIG. 1 is a block diagram illustrating an access controller using a conventional cache memory chip.

FIG. 2 is a block diagram illustrating the first embodiment of an access controller using the cache memory of this invention.

FIG. 3 is a block diagram illustrating an internal configuration of the cache memory chip used in the embodiment in FIG. 2.

FIG. 4 is a block diagram illustrating the second embodiment of this invention.

FIG. 5 is a block diagram illustrating the third embodiment of this invention.

FIG. 6 is a block diagram illustrating the fourth embodiment of this invention.

FIG. 7 is a block diagram illustrating the fifth embodiment of this invention.

## DESCRIPTION OF THE PREFERRED EMBODIMENT

Referring to the drawings, the embodiments will be described below.

FIG. 2 shows an embodiment of an access controller using the cache memory according to this invention. A cache memory chip 5 has the internal hit signal generation circuit 6 which generates hit signals of the memory itself, and an OR circuit 7 is formed on a single semiconductor substrate. The entire cache memory chip, including the OR circuit 7, forms a single chip 5. One input of the OR circuit 7 is connected with the output of the internal hit signal generation circuit 6, the other input with the external input terminal 8 of the chip 5 and the output with the hit signal output terminal 9 of the chip 5.

The external input terminal 8 is supplied with ready signals from an I/O ready signal generation circuit 3 and the output signal from the hit signal output terminal 9 is fed to the ready signal input of an MPU 1. The output address of the MPU 1 is provided to both the cache memory chip 5 and the I/O ready signal generation circuit 3.

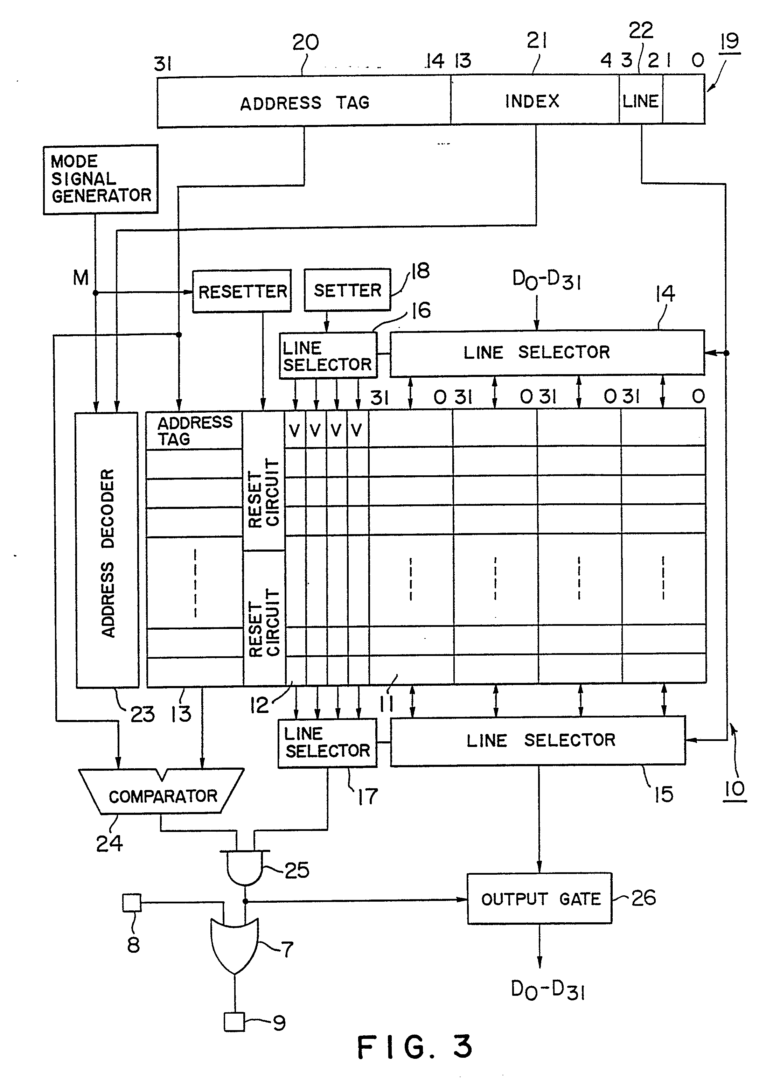

FIG. 3 shows an internal configuration of the cache memory chip 5. Although the same configuration as a general cache memory may be applied to the cache memory chip 5 except the OR circuit 7, the configuration proposed in Japanese Patent Application 1987-332177 is used for this embodiment. Since the details are described in that specification, description for only the parts relating directly to the invention will be provided here. The cache storage 10 has many entries (shown by rows), and each entry comprises a data division 11, a valid bit division 12 and an address tag division 13. The data division 11 is divided into multiple data areas of 32 bits each (called "line"), one of these multiple lines is selected by line selectors 14 and 15 and data enter and leave the lines. Multiple valid bits corresponding to multiple lines are provided in the valid bit division 12. When the line is selected as mentioned above, one corresponding valid bit is selected by line selectors 16 and 17. The valid bit is set to 1 by a setter 18 when data are written in the corresponding line.

An address 19 given by MPU 1 has an address tag 20, an index 21 and a line 22. The index 21 specifies an entry, and according to the index an address decoder 23 selects the entry. When data is written, an address tag 20 is written in the address tag division 13 in the selected entry, the data is written in the line specified by the line 22 and the valid bit corresponding to the line is set to 1.

On the other hand, when data is read, the address tag is read from the address tag division 13, and the read address tag is compared in a comparator 24 with the address tag 20 from the MPU. If the tags coincide with each other, the comparator 24 outputs 1. Also, the value of the valid bit specified by line 22 is read by a line selector 17, and this value and the output of the collator 24 are fed to an AND circuit 25. If both values are 1, the internal hit signal is issued from the AND circuit 25 and becomes an input of the OR circuit 7 as described above. The internal hit signal also opens an output gate 26 and the data read out of the line is output to the data bus through the output gate 26.

Although the whole configuration in FIG. 3 is formed as a single chip 5 in this embodiment, the configuration may be divided into several chips. In this case, however, the internal hit signal generation circuit 6 in FIG. 2, comprising a valid bit division 13, line selector 17, address tag division 13, address decoder 23, comparator 24 and AND circuit 25 in FIG. 3, is fabricated as a single chip including the OR circuit 7.

In the configuration as described above, the internal hit signal issued by the cache memory itself is transmitted to the MPU 1 via the OR circuit 7 in the same chip. The wiring distance between the circuits in the same chip 5, compared with that in separate chips, is so short as to be negligible, and the wiring resistance and the time constant attributable to the capacity are so small as to be negligible. Thus, the internal hit signal is transmitted to the MPU 1 at a very high speed when compared with the prior art. On the other hand, because ready signals from the I/O ready signal generation circuit 3 are transmitted via the cache memory chip 5, which is a chip other than the circuit, transmission delay occurs as in the prior art. However, this delay presents no practical problems because a speed as high as that for the hit signals is not required.

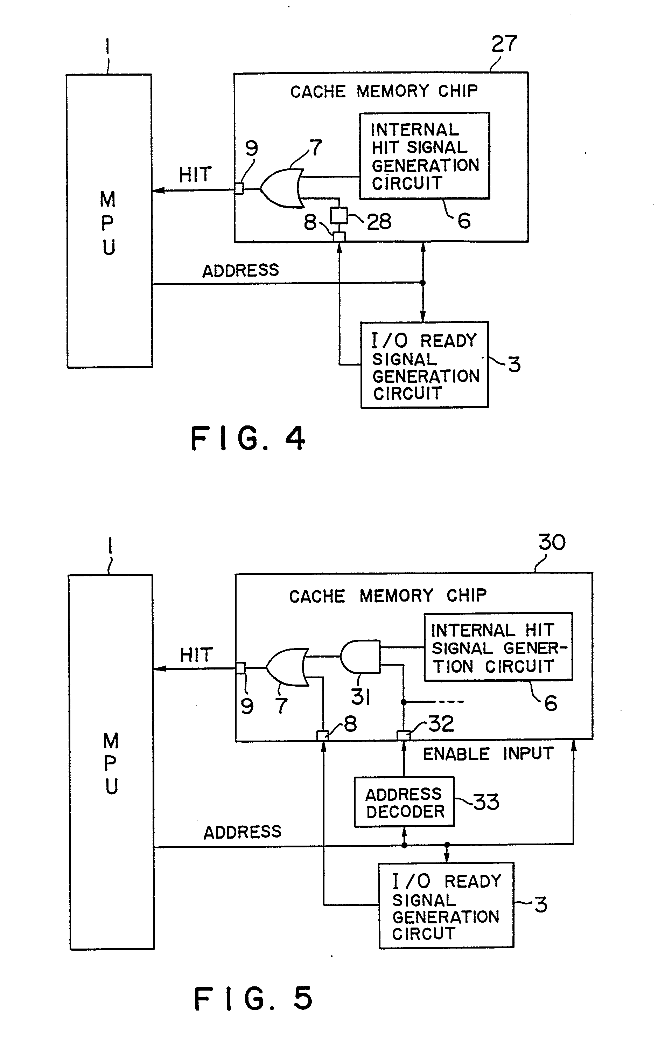

However, transmission delays may cause a problem of asynchronization with the clock of the MPU 1, of the timing at which the ready signals are given to the MPU 1. To solve this problem, in the embodiment shown in FIG. 4, a latch circuit 28 is provided in the cache memory chip 27 in addition to the memory chip components shown in FIG. 2. The latch circuit 28 latches the ready signals entering the chip through the external input terminal 8 and sends the signals to the OR circuit 7, in synchronization with the clock. Thus, the timing at which the ready signals are given to the MPU 1 is made properly.

FIG. 5 shows the third embodiment of the invention. The cache memory chip 30 of this embodiment has an AND circuit 31 in addition to the configuration in FIG. 2. One of inputs of the AND circuit 31 is supplied with internal hit signals and the other input is connected to an enable input terminal 32 of the chip 30. The outputs of the AND circuit 31 and the I/O ready generation circuit 3 are sent out of a hit signal output terminal 9 via an OR circuit 7.

The enable input terminal 32 is supplied with chip enable signals from an address decoder 33.

Such a configuration is suitable for cases where multiple cache memories are used, and even when the internal hit signal is formed in the cache memory, the internal hit signals of the chip are sent out unless the chip enable signal is fed to the cache memory.

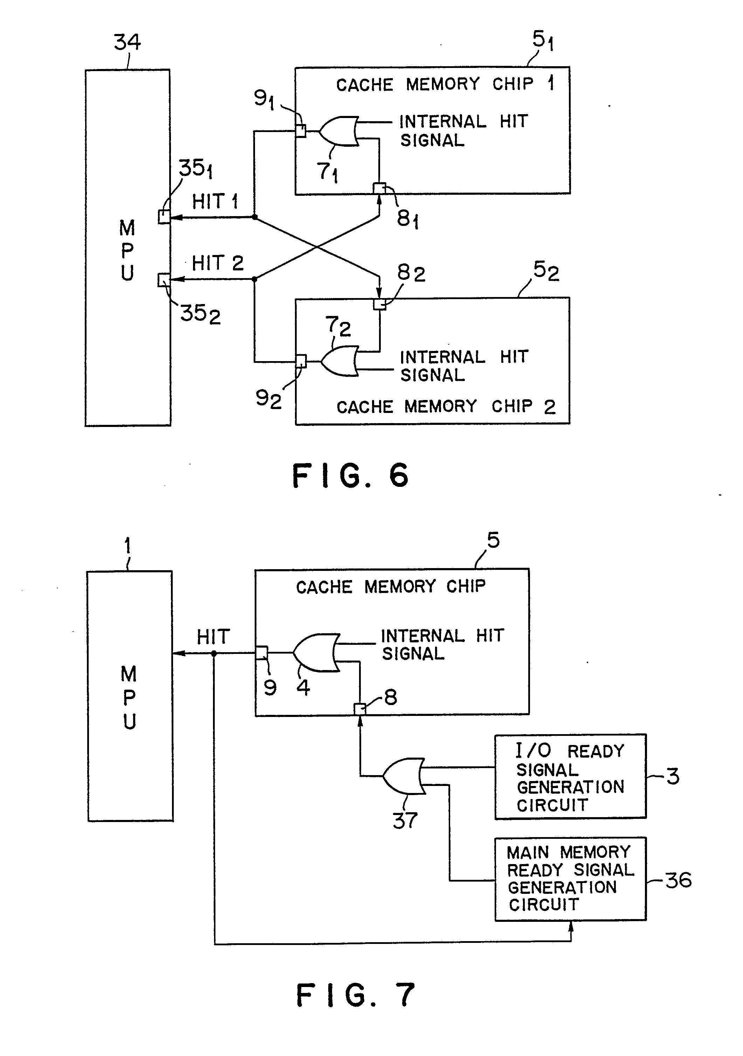

FIG. 6 shows an embodiment of an access controller using two cache memories. Such an MPU is used for the MPU 34 that has two ready input terminals $35_1$ and $35_2$ and recognizes the formation of the ready (hit) condition by the ready (hit) signal first fed into either of the terminals and judges the number of bits of the data in access to be 32 bits when the other terminal is also supplied with the ready (hit) signal even with some delay, 16 bits when only terminal $35_1$ is supplied with the signal, or 8 bits when only the terminal $35_2$ is supplied with the signal. In this configuration, the MPU 34 is connected with two cache memory chips $5_1$ and $5_2$ of the same configuration as used in the first embodiment and is designed to judge the data to be 32-bit data even when the formation of hit condition occurs in either cache memory.

Hit output terminals $9_1$ and $9_2$ of the cache memory chips $5_1$ and $5_2$ are connected to ready input terminals $35_1$ and $35_2$ of the MPU 34, respectively, and the hit output terminal 9 of one chip 5 is crosswise connected to the external hit input terminal 8 of another chip to intersect one another.

According to such a configuration, for example, when an internal hit signal is formed in the first chip $5_1$, this signal is immediately fed as the first hit signal, HIT 1, to the HIT input terminal $35_1$ of the MPU 34 and the MPU 34 recognizes the formation of hit condition. At the same time, the first hit signal HIT 1 is fed as an external signal to the second chip $5_2$, and then with some delay, through an OR circuit $7_2$ of the chip, to the second ready signal input terminal $35_2$ as the second hit signal HIT 2. Thus the MPU 34 judges the signal to be 32-bit data.

In addition, the cache memory chips $5_1$ and $5_2$ in FIG. 6 may be replaced by the chip 30 used in FIG. 5.

FIG. 7 shows the fourth embodiment of an access controller according to the invention. In this configuration, when the internal hit signal is not formed in the cache memory 5 used in FIG. 2, the ready signals of the main memory are given to MPU 1 so that the data can be read out of the main memory. A main memory ready signal generation circuit 36 is connected to the hit signal output terminal 9 of the cache memory chip 5 and generates the ready signal for the main memory only when no hit signal has been sent from terminal 9. The ready signal for the main memory and the ready signal from the I/O ready signal generation circuit 3 are fed to the external signal input terminal 8 of the cache memory chip 5 via the OR circuit 37.

If in this configuration the data wanted by MPU 1 is in the cache memory chip 5, the internal hit signal is formed and access to the cache memory chip 5 is made. If the data wanted by MPU 1 is not in the cache memory chip 5, the ready signal for the main memory is formed because the internal hit signal has not been formed, and access to the main memory is made. In this case the ready signal of the main memory is transmitted with some delay because it is transmitted via the OR circuit 37 or the cache memory chip 5. However, this delay presents no practical problems because the access rate of the main memory is slow.

In addition, the cache memory chip 5 in FIG. 7 may be replaced by the chip 27 used in FIG. 4 or the chip 30 used in FIG. 5.

The scope of this invention is not limited to the above-described embodiments and also covers the modified embodiments without departing from the gist of the invention. Although the cache memory chips in the above-described embodiments have one external input terminal for generating hit signals, for example, chips that are provided with two or more terminals and which may transmit external and internal hit signals through a multi-input OR circuit are included in the scope of this invention. If such a cache memory is applied to the embodiment in FIG. 7, the OR circuit 37 can be eliminated.

As described above, according to this invention, because the hit signal generation circuit of the cache memory and the OR circuit to feed the hit signals to the processor are mounted on the same chip, the hit signals of the cache memory are transmitted to the processor at a high speed, and so the processor can operate at a high speed without unnecessary delay, to allow increases in speed.

Reference signs in the claims are intended for better understanding and shall not limit the scope.

## Claims

1. A cache memory characterized by comprising, in the same chip, address tag divisions (13) storing address tags of stored data, a comparator (24) comparing an address tag (20) in external address (19) with the address tags in the address tag divisions (13), a circuit (25) generating an internal hit signal depending on the output of the collator (24), and an OR circuit (7) outputting an OR signal of logical sum of the internal hit signal and an external signal.

2. A cache memory as defined in claim 1, characterized by having data divisions (11) storing the data and the address tag divisions (13) in the same chip.

3. A cache memory as defined in claim 1, characterized by having a latch circuit (28) latching the external hit signal and feeding the external hit signal to the OR circuit (7) in the same chip.

4. A cache memory as defined in claim 1, characterized by having a gate circuit (31) feeding the internal hit signal to the OR circuit (7) only when an external enable signal is given.

5. An access controller for a processor using a cache memory as defined in claim 1, characterized in that output of an I/O ready signal generation circuit (3) is given as the external signal to the cache memory (5) and the OR signal from the cache memory (5) is given to a ready signal input terminal of the processor (1).

6. An access controller for a processor utilizing a cache memory as defined in claim 4, characterized in that output of an I/O ready signal generation circuit (3) is given as the external hit signal to the cache memory (30), a chip enable signal from an address decoder (33) is given as the enable signal to the cache memory (30) and the OR signal from the cache memory (30) is given to a ready signal input terminal of the processor (1).

7. An access controller as defined in claim 5, characterized in that multiple cache memories (5_1, 5_2) are provided, the processor (34) has multiple ready signal input terminals (35_1, 35_2), the OR signals from said multiple cache memories (5_1, 5_2) are given to the ready signal input terminals (35_1, 35_2) respectively and the OR signal from each of the cache memory is given as the external hit signal to the other cache memories (5_1, 5_2).

8. An access controller as defined in claim 6, characterized in that multiple cache memories (5_1, 5_2) are provided, the processor (34) has multiple ready signal input terminals (35_1, 35_2), the OR signals from said multiple cache memories (5_1, 5_2) are given to the ready signal input terminals (35_1, 35_2) respectively and the OR signal from each of the cache memory is given as the external hit signal to the other cache memories (5_1, 5_2).

9. An access controller as defined in claim 5 or claim 6, characterized in that a main memory ready signal generation circuit (36) generating main memory ready signal when the internal hit signal has not been formed in the cache memory (5) is provided and outputs of the main memory ready signal generation circuit (36) and the I/O ready signal generation circuit (3) are given as the external signal to the cache memory (5).

10. An access controller as defined in claim 6, characterized in that a main memory ready signal generation circuit (36) generating main memory ready signal when the internal hit signal has not been formed in the cache memory (5) is provided and outputs of the main memory ready signal generation circuit (36) and the I/O ready signal generation circuit (3) are given as the external signal to the cache memory (5).

FIG. 1 PRIOR ART

FIG. 2

F I G. 3

F I G. 4

F I G. 5

F I G. 6

F I G. 7